# EUROPÄISCHE PATENTSCHRIFT

(11) **EP 1 292 016 B1**
(45) Veröffentlichungstag und Bekanntmachung des Hinweises auf die Patenterteilung: **09.03.2005**
(21) Anmeldenummer: 02102223.1
(22) Anmeldetag: 27.08.2002
(51) Int. Cl.: H03D 3/00

(54) **Schaltungsanordnung zur Demodulation von Signalen**
Circuit for demodulating signals
Circuit de démodulation de signaux

(30) Priorität: 28.08.2001 DE 10142019
(43) Veröffentlichungstag der Anmeldung: 12.03.2003
(73) Patentinhaber: Philips Intellectual Property & Standards GmbH, 20099 Hamburg (DE); Koninklijke Philips Electronics N.V., 5621 BA Eindhoven (NL)
(72) Erfinder: Kohsiek, Cord Heinrich, 52088, Aachen (DE)
(74) Vertreter: Volmer, Georg, Dipl.-Ing.

(56) Entgegenhaltungen:
- US-A- 4 991 226
- US-A- 5 079 526

## Beschreibung

Die Erfindung betrifft eine Schaltungsanordnung zur Demodulation von Signalen, insbesondere frequenzmodulierten Signalen, wobei auf einen Begrenzer, dessen Eingang die zu demodulierenden Signale zuführbar sind, ein Demodulator folgt, an dessen Ausgang die demodulierten Signale entnehmbar sind.

Schaltungsanordnungen nach der Gattung des Hauptanspruchs werden seit langem in verschiedenen Empfängern, beispielsweise in Rundfunkempfängern, angewendet und beispielsweise im Valvo Handbuch "Integrierte Analog-Schaltungen für Rundfunk- und NF-Anwendungen, 1981", Seite 60 oder im Dokument US 5 079 526 A dargestellt. Neben dem gewünschten demodulierten Ausgangssignal erzeugt der Demodulator auch unerwünschte Reste der Trägerfrequenz bzw. der Zwischenfrequenz. Wenn demodulierte Signale ausgewertet werden sollen, deren Frequenz in der Nähe dieser unerwünschten Frequenzen liegt, ist die Signalverarbeitung gestört. Solche Störung tritt beispielsweise im FM-Demodulator eines Autoradios mit niedriger Zwischenfrequenz auf.

Aufgabe der Erfindung ist es, störende Trägerreste am Ausgang des Demodulators zu unterdrücken. Diese Aufgabe wird mit der erfindungsgemäßen Schaltungsanordnung dadurch gelöst, daß die Ausgänge des Demodulators und des Begrenzers mit je einem Eingang eines Mischers verbunden sind, dessen Ausgang über einen Tiefpaß an den Eingang des Begrenzers angeschlossen ist.

Die Erfindung beruht auf der Erkenntnis, daß für die obengenannten Störungen herstellungsbedingte Streuungen von Parametern (Offsets) der verwendeten Bauelemente ursächlich sind, die eine unsymmetrische Signalverarbeitung erzeugen. Durch die erfindungsgemäßen Maßnahmen können diese Offsets weitgehend reduziert werden.

Der Restanteil der Zwischenfrequenz im Ausgangssignal ist dadurch sehr viel kleiner als bei bisher üblichen Schaltungen.

Zur phasengleichen Mischung kann es je nach Voraussetzungen im einzelnen vorteilhaft sein, gemäß einer Weiterbildung der erfindungsgemäßen Schaltungsanordnung vorzusehen, daß der Ausgang des Begrenzers über eine Verzögerungseinrichtung mit dem einen Eingang des Mischers verbunden ist.

Eine weitere vorteilhafte Ausgestaltung besteht darin, daß die Grenzfrequenz des Tiefpasses unterhalb des Frequenzbandes der zu demodulierenden Signale liegt.

Ferner ist es vorteilhaft vorzusehen, daß das zu demodulierende Signal ein Zwischenfrequenzsignal ist, das über einen Bandpaß zuführbar ist.

Ausführungsbeispiele der Erfindung sind in der Zeichnung anhand mehrerer Figuren dargestellt und in der nachfolgenden Beschreibung näher erläutert. Es zeigt:
Fig. 1 ein Blockschaltbild eines Ausführungsbeispiels der erfindungsgemäßen Schaltungsanordnung und
Fig. 2 ein Blockschaltbild einer an sich bekannten Schaltungsanordnung.

Gleiche Teile sind in den Figuren mit gleichen Bezugszeichen versehen.

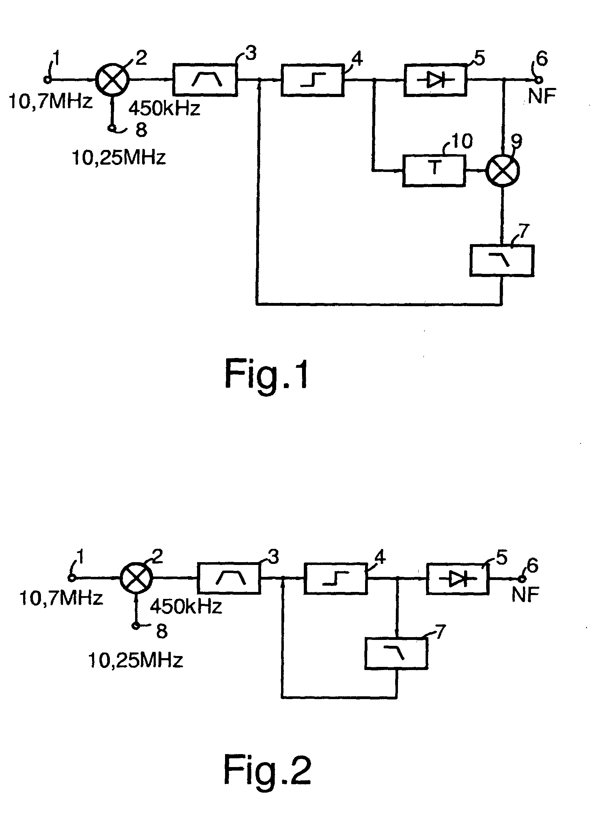

Die bekannte Schaltungsanordnung nach Fig. 2 stellt einen Teil eines Empfängers, beispielsweise eines Autoradios, dar. Bei 1 wird von einem UKW-Empfangsteil ein Zwischenfrequenzsignal mit einer Frequenz von 10,7 MHz zugeführt. In einem Mischer 2 wird anhand eines bei 8 zugeführten 10,25-MHz-Signals eine niedrigere Zwischenfrequenz von 450 KHz erzeugt, die über einen Bandpaß 3 geleitet wird.

Darauf folgt der Begrenzer 4, der üblicherweise als begrenzender Verstärker ausgeführt ist. Das somit amplitudenbegrenzte frequenzmodulierte Zwischenfrequenzsignal wird in einem Demodulator 5 demoduliert. An dessen Ausgang steht das Niederfrequenzsignal NF zur Verfügung. Zur Arbeitspunktstabilisierung des Begrenzers 4 wird der Gleichspannungsanteil eines Ausgangssignals mit Hilfe eines Tiefpasses 7 abgetrennt und auf den Begrenzereingang zurückgeführt.

Bei der in Fig. 1 dargestellten erfindungsgemäßen Schaltung wird das Ausgangssignal des Begrenzers 4 mit dem Ausgangssignal des Demodulators 5 in einem weiteren Mischer 9 multipliziert. Da die Multiplikation phasenrichtig zu erfolgen hat, ist eine Verzögerungsschaltung 10 vorgesehen, um die Laufzeit innerhalb des Demodulators auszugleichen. Das Mischprodukt wird über einen Tiefpaß 7 wie bei der bekannten Schaltung an den Eingang des Begrenzers 4 zurückgeführt.

## Patentansprüche

1. Schaltungsanordnung zur Demodulation von Signalen, insbesondere frequenzmodulierten Signalen, wobei auf einen Begrenzer, dessen Eingang die zu demodulierenden Signale zuführbar sind, ein Demodulator folgt, an dessen Ausgang die demodulierten Signale entnehmbar sind,
**dadurch gekennzeichnet,**
**dass** die Ausgänge des Demodulators (5) und des Begrenzers (4) mit je einem Eingang eines Mischers (9) verbunden sind, dessen Ausgang über einen Tiefpass (7) an den Eingang des Begrenzers (4) angeschlossen ist.

2. Schaltungsanordnung nach Anspruch 1,
**dadurch gekennzeichnet,**
**dass** der Ausgang des Begrenzers (4) über eine Verzögerungseinrichtung mit dem einen Eingang des Mischers (9) verbunden ist.

3. Schaltungsanordnung nach einem der vorhergehenden Ansprüche,
**dadurch gekennzeichnet,**
**dass** die Grenzfrequenz des Tiefpasses (7) unterhalb des Frequenzbandes der zu demodulierenden Signale liegt.

4. Schaltungsanordnung nach einem der vorhergehenden Ansprüche,
**dadurch gekennzeichnet,**
**dass** das zu demodulierende Signal ein Zwischenfrequenzsignal ist, das über einen Bandpaß (3) zuführbar ist.

## Claims

1. A circuit arrangement for demodulating signals, particularly frequency-modulated signals, in which a limiter, to whose input the signals to be modulated can be applied, is followed by a demodulator from whose output the demodulated signals can be derived,
**characterized in that**
the outputs of the demodulator (5) and the limiter (4) are connected to a respective input of a mixer (9) whose output is connected to the input of the limiter (4) via a low-pass filter (7).

2. A circuit arrangement as claimed in claim 1,
**characterized in that**
the output of the limiter (4) is connected to the one input of the mixer (9) via a delay device.

3. A circuit arrangement as claimed in any one of the preceding claims,
**characterized in that**
the limit frequency of the low-pass filter (7) is below the frequency band of the signals to be demodulated.

4. A circuit arrangement as claimed in any one of the preceding claims,
**characterized in that**
the signal to be demodulated is an intermediate frequency signal which can be applied via a bandpass filter (3).

## Revendications

1. Circuit de démodulation de signaux, en particulier de signaux à modulation de fréquence, un démodulateur à l'entrée duquel les signaux démodulés peuvent être prélevés suivant un limiteur à l'entrée duquel peuvent être amenés les signaux à démoduler,
**caractérisé en ce**
**que** les sorties du démodulateur (5) et du limiteur (4) sont respectivement reliées à une entrée d'un mélangeur (9) dont la sortie est raccordée par l'intermédiaire d'un filtre passe-bas (7) à l'entrée du limiteur (4).

2. Circuit selon la revendication 1,
**caractérisé en ce**
**que** la sortie du limiteur (4) est reliée par l'intermédiaire d'un dispositif retardateur à une entrée du mélangeur (9).

3. Circuit selon une des revendications précédentes,
**caractérisé en ce**
**que** la fréquence-limite du filtre passe-bas (7) est inférieure à la gamme de fréquence des signaux à démoduler.

4. Circuit selon l'une des revendications précédentes,
**caractérisé en ce**
**que** le signal à démoduler est un signal de fréquence intermédiaire qui peut être amené par l'intermédiaire d'un filtre passe-bande (3).
